# EUROPEAN PATENT APPLICATION

(11) **EP 4 231 529 A1**
(43) Date of publication of application: **23.08.2023**
(21) Application number: 23157228.0
(22) Date of filing: 17.02.2023
(51) Int. Cl.: H03K 17/97

(54) **WIRELESS SWITCH**

(30) Priority: 19.02.2022 CN 202220336880 U
(71) Applicant: Shenzhen Eco-Newleaf Co., Ltd., Shenzhen, Guangdong 518000 (CN)
(72) Inventor: Chen, Hongying, Shenzhen, 518000 (CN)
(74) Representative: Cleanthous, Marinos

(57) **Abstract**

Provided is a wireless switch, configured to control a controlled device. The wireless switch includes a key panel and a power generation module. The power generation module includes a drive part, a moving part, an induction part, and a reset component. When the key panel is subjected to a control action of pressing, the drive part undergoes elastic deformation to drive the moving part, thus making the moving part move towards a first direction; and the reset component undergoes elastic deformation to produce a reset force to overcome the deformation. When the pressing force on the key panel is removed, the reset force is used by the reset component to urge the elastic recovery of the drive part to drive the moving part, thus making the moving part move towards a second direction and making the key panel rebound. According to the present disclosure, the wireless switch can achieve stable and efficient power generation and power supply, and guarantee the accuracy and timeliness of information sending, thereby guaranteeing the timeliness and accuracy of control between the wireless switch and the controlled device.

## Description

### TECHNICAL FIELD

The present disclosure relates to the field of switches, and in particular to a wireless switch.

### BACKGROUND

At present, traditional switches are generally used in home decoration, most of which are mounted by wiring; and mounting of such a switch requires the chiseling of a cable groove on the wall, which is time-consuming, laborious, high in cost, and inconvenient for maintenance in the later period. Moreover, the visual pleasing is affected by wiring, and the difficulty of wiring in a complicated space makes it impossible to complete the wiring. To solve the problems above, wireless switches are also used in existing indoor switches. However, the existing wireless switches have several disadvantages: the noise is loud, the hand feeling is heavy, the electric quantity is unstable, the switch can be turned on/off only by pressing the key repeatedly, the service life is short, the structure is complex, and the control is insensitive and inaccurate.

### SUMMARY

In view of above content, the present disclosure aims to at least solve one of the technical problems in the prior art. To this end, a wireless switch is provided by the present disclosure. The wireless switch can achieve stable and efficient power generation and power supply, and guarantee the accuracy and timeliness of information sending, thereby guaranteeing the timeliness and accuracy of control between the wireless switch and a controlled device.

A wireless switch provided by an embodiment of the present disclosure is configured to control a controlled device. The wireless switch includes at least one key panel and a power generation module. The power generation module includes a drive part, a moving part, an induction part, and a reset component. When the key panel is subjected to a control action of pressing, the drive part undergoes elastic deformation to drive the moving part, thus making the moving part move towards a first direction; and the reset component undergoes elastic deformation to produce a reset force to overcome the deformation. When the pressing force on the key panel is removed, the reset force is used by the reset component to urge the elastic recovery of the drive part to drive the moving part, thus making the moving part move towards a second direction and making the key panel rebound.

In some embodiments, the wireless switch further includes a fixing frame, the key panel is provided with a pin hole, the fixing frame is provided with a hinge pin, and the key panel can be rotatably mounted into the fixing frame by inserting the hinge pin into the pin hole.

In some embodiments, the wireless switch further includes a base, and the fixing frame can be covered with the base to form an accommodating space, and the power generation module is accommodated into the accommodating space.

In some embodiments, the wireless switch further includes a sealing member. The sealing member can cover the power generation module to prevent external dust or liquid from entering. One side, close to the power generation module, of the sealing member is provided with a noise reduction part, and the noise reduction part is of a wavy structure to increase the damping of sound propagation, thereby reducing the sound generated when the key panel is pressed.

In some embodiments, the reset component and the sealing member are both made of a silica gel material.

In some embodiments, the wireless switch further includes a control circuit. The control circuit includes a rectifier module, and the induction part is electrically connected to the rectifier module, so as to generate an induced voltage when the moving part moves towards the first direction as well as the second direction.

In some embodiments, the control circuit further includes an energy storage module, and the rectifier module is electrically connected to the energy storage module. The rectifier module includes a first rectifier diode and a second rectifier diode, and the induced voltage generated by the power generation module is stored in a tantalum capacitor of the energy storage module after passing through the first rectifier diode and a second rectifier diode in the rectifier module.

In some embodiments, the control circuit further includes a voltage output module, a processor, a memory, and a wireless communication module. The energy storage module is electrically connected to the voltage output module, the voltage output module is electrically connected to the processor, the memory and the wireless communication module, so as to output a required power supply voltage to the processor, the memory and the wireless communication module by using electric energy transmitted from the energy storage module, and thus the processor, the wireless communication module and the memory are powered on.

In some embodiments, the voltage output module is provided with a voltage division circuit. The voltage division circuit is provided with a fourth rectifier diode and two voltage division resistors, and an emission node is arranged between the two voltage division resistors. The emission node is used as a signal output end of the voltage output module to output a steady signal.

In some embodiments, the wireless communication module can be in communication with the controlled device, and the processor is electrically connected to the wireless communication module, so as to send a control instrument to the controlled device by using the wireless communication module after the processor, the memory and the wireless communication module are powered on.

The wireless switch provided by the present disclosure is internally provided with the power generation module, and when the key panel is pressed, the moving part moves with respect to the induction part to generate electric energy by using the principle of electromagnetic induction power generation. In addition, under the action of the reset component, the key panel and the moving part can be driven to rebound automatically, thus making the induction part continue to generate electric energy. Therefore, the bidirectional power generation when the key panel is pressed and rebounds is achieved, the power generation efficiency is improved, and the timeliness and accuracy of the control between the wireless switch and the controlled device is guaranteed. Moreover, the present disclosure has the features of simple structure, large and stable electric power generation, environmental protection, low cost, and convenient mounting.

### BRIEF DESCRIPTION OF THE DRAWINGS

FIG. 1 is a configuration diagram of a wireless switch and a controlled device according to an embodiment of the present disclosure;
FIG. 2 is a block diagram of a wireless switch according to an embodiment of the present disclosure;
FIG. 3 is a structure diagram of a wireless switch according to an embodiment of the present disclosure;
FIG. 4 is another structure diagram of a wireless switch according to an embodiment of the present disclosure;
FIG. 5 is a schematic diagram of a control circuit of a wireless switch according to an embodiment of the present disclosure;
FIG. 6 is a schematic diagram of another control circuit of a wireless switch according to an embodiment of the present disclosure.

In the drawings:
100-wireless switch;
10-key panel; 11-pin hole; 12-snap;
20-fixing frame; 21-hinge pin; 25-through hole; 30-sealing member; 31-bulge; 32-noise reduction part;
40-power generation module; 41-drive part; 42-moving part; 43-induction part; 45-reset component;
50-base; 51-screw hole; 53-key; 55-mounting hole;
60-control circuit; 61-circuit board; 62-rectifier module; 63-energy storage module; 64-voltage output module;
65-processor; 66-memory; 67-wireless communication module.

### DETAILED DESCRIPTION OF THE EMBODIMENTS

The embodiments of the present disclosure are described in detail below. Examples of the embodiments are shown in the accompanying drawings, and the same or similar numbers throughout this specification represent the same or similar elements or elements having the same or similar functions. The embodiments described below with reference to the accompanying drawings are exemplary, and are intended to explain the present disclosure, but cannot be construed to limit the present disclosure.

The disclosure below provides many different embodiments or examples to implement different structures of the present disclosure. To simplify the disclosure of the present disclosure, the components and settings in the specific examples are described below. Certainly, these are merely examples, and the objective is not to limit the present disclosure. In addition, in the present disclosure, reference numerals and/or letters may be repeated in different examples Such repetition is for the purpose of simplification and clarity, but the repeated numerals and/or letters do not indicate relationships between discussed various embodiments and/or settings. In addition, the present disclosure provides examples of various particular processes and materials, but a person of ordinary skill in the art may realize applicability of another process and/or use of another material.

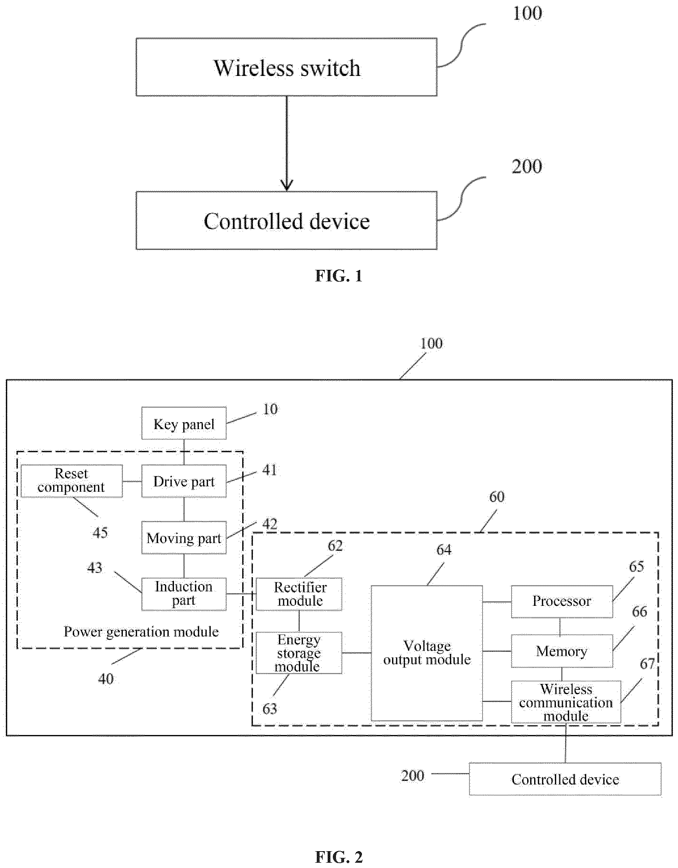

Please refer to FIG. 1, it is provided a wireless switch 100 according to an embodiment of the present disclosure, which is configured to control a controlled device 200. In an actual control system, the number of the wireless switches 100 and the controlled device 200 can be multiple. Meanwhile, the transmission of wireless signals can be achieved between the wireless switch 100 and the controlled device 200, and the wireless signals may be Bluetooth, radio frequency, Wifi, and the like.

In an embodiment of the present disclosure, the controlled device 200 may be any controlled device capable of being controlled by the wireless switch 100. Specifically, the controlled device 200 may be a wall switch, an electronic doorbell, a light, an automatic curtain, a fan, and the like.

Please refer to FIG. 2 to FIG. 4, the wireless switch 100 includes a key panel 10, a fixing frame 20, a sealing member 30, a power generation module 40, a base 50, and a control circuit 60. The control circuit 60 includes a circuit board 61, a rectifier module 62, an energy storage module 63, a voltage output module 64, a processor 65, a memory 66, and a wireless communication module 67. The power generation module 40, the rectifier module 62, the energy storage module 63, the voltage output module 64, the processor 65, the memory 66 and the wireless communication module 67 may be connected to the circuit board 61.

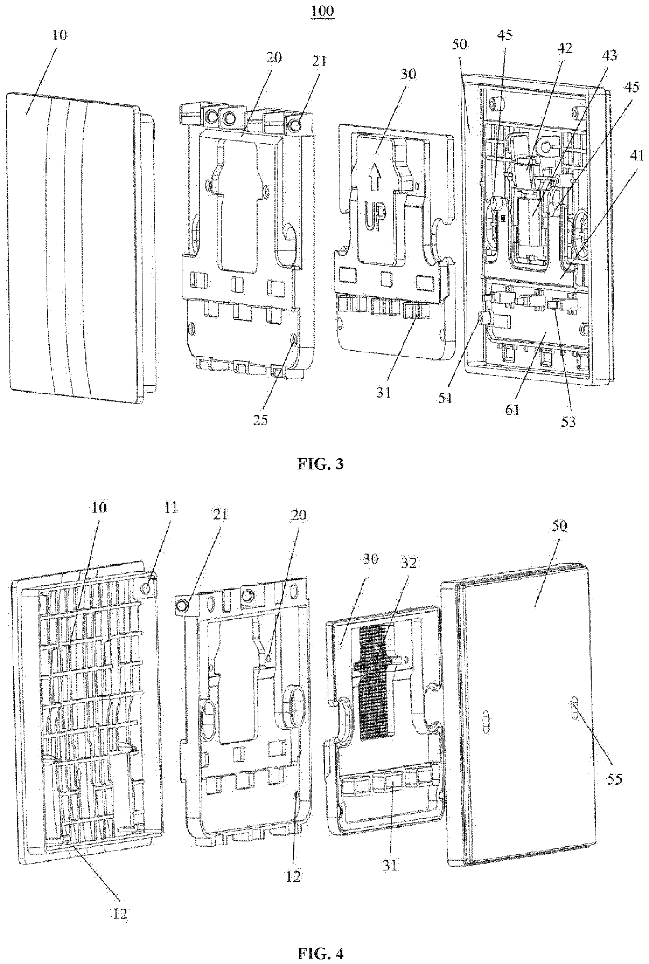

Please refer to FIG. 3 and FIG. 4, the upper part of the key panel 10 is provided with a pin hole 21, the upper part of the fixing frame 20 is provided with a hinge pin 21, and the key panel 10 can be rotatably mounted into the fixing frame 20 by inserting the hinge pin 21 into the pin hole 11. Snaps 12 are further provided below the key panel 10, and the snaps 12 are configured to fix the key panel 10 to the fixing frame 20.

The fixing frame 20 can be covered with the base 50 to form an accommodating space; and the sealing member 30, the power generation module 40 and the control circuit 60 are accommodated into the accommodating space. The fixing frame 20 and the sealing member 30 each are provided with multiple through holes 25, the base 50 is provided with multiple screw holes 51 corresponding to the through holes 25, and multiple fasteners (not shown in figure) may penetrate through the through holes 25 of the fixing frame 20 and the sealing member 30 and then are inserted into the screw holes 51 to fix the fixing frame 20 and the base 50 together. The sealing member 30 can cover the power generation module 40 and the control circuit 60 to prevent external dust or liquid from entering. One side, close to the power generation module 40, of the sealing member 30 is further provided with a noise reduction part 32. The noise reduction part 32 of a wavy structure may increase the damping of sound propagation, thereby reducing the sound generated by the key panel 10 when pressed. In the embodiments of the present disclosure, in order to make the sealing member 30 seal the power generation module 40 and the control circuit 60 better and possess better noise reduction and reset capacity, the sealing member 30 may be made of a silica gel material.

Please refer from FIG. 2 to FIG. 4, when the key panel 10 is manipulated (e.g., pressed and/or rebound), the power generation module 40 may generate electricity to produce electric energy, and the electric energy may be configured to directly or indirectly supply power to the processor 65, the memory 66, and the wireless communication module 67. Further, the power generation module 40 includes a drive part 41, a moving part 42, and an induction part 43. When the key panel 10 is subjected to a manipulation action of pressing, the drive part 41 undergoes elastic deformation to drive the moving part 42, thus making the moving part 42 move towards a first direction; and when the key panel 10 is subjected to a manipulation action of rebounding, the drive part 41 is elastically recovered to make the moving part 42 move towards a second direction opposite to the first direction. When the moving part 42 moves towards the first direction as well as the second direction, the induction part 43 may generate an induced voltage.

The moving part 42 can be driven by at least one of the key panel 10 and the drive part 41 to move, the induction part 43 can interact with the moving part 42, so as to induce the component or the combination of components which generates the electric energy when the moving part 42 moves. Any structure in the field that can generate electric energy based on motion can be used as an alternative to the embodiment of the present disclosure.

It may be understood that a permanent magnet part, a magnetic conduction part and a coil part can be configured in the power generation module 40, where the coil part can be arranged on the magnetic conduction part. When the permanent magnet part moves with respect to the magnetic conduction part, the coil part can generate an induced voltage. The coil part can be regarded as the induction part 43 mentioned above, and the permanent magnet part or the magnetic conduction part can be regarded as the moving part 42 mentioned above. In addition, the induction part 43 may or may not move along with the moving part 42, which is not limited in the present disclosure.

In the embodiments of the present disclosure, to make the drive part 41 and the moving part 42 elastically recover better, the power generation module 40 further includes two reset components 45. When the key panel 10 is subjected to a manipulation action of pressing, the drive part 41 undergoes elastic deformation to drive the moving part 42, thus making the moving part move towards a first direction; and the reset components 45 undergo elastic deformation to produce a reset force to overcome the deformation. When the pressing force on the key panel 10 is removed, the reset force is used by the reset components 45 to urge the elastic recovery of the drive part 41 to drive the moving part 42, thus making the moving part 42 move towards a second direction and making the key panel 10 rebound. It may be understood that the reset component 45 is made of a material with good elastic deformation. Preferably, the reset component 45 may be made of a silica gel material.

The base 50 is further provided with multiple keys 53 electrically connected to the circuit board 61 and the processor 65, the sealing member 30 is provided with bulges 31 corresponding to the keys 53, and the bulges 31 can be sleeved outside the keys 53. When the key panel 10 is pressed, the sealing member 30 is elastically pressed, and the key 53 at a corresponding region is elastically compressed to cause the generation of a corresponding signal on the circuit board 61, and then the corresponding signal is received by the processor 65. Each key 53 may be preset to be bound with different controlled devices 200, e.g., a wall switch, an electronic doorbell, a light, an automatic curtain, and a fan.

Both sides of the base 50 are further provided with mounting holes 55, and the base 50 can be fixedly mounted to a to-be-mounted position when the fasteners penetrate through the mounting holes 55. It may be understood that the base 50 may be directly attached to the wall or other places with double-sided adhesive tape, and may also be mounted in the traditional switch bottom case with screws.

The wireless switch 100 provided by the embodiment of the present disclosure is internally provided with a power generation module 40. When the key panel 10 is pressed, the moving part 42 moves with respect to the induction part 43 to generate electric energy by using the principle of electromagnetic induction power generation. In addition, under the action of the reset component 45, the key panel 10 and the moving part 42 can be driven to rebound automatically, thus making the induction part 43 continue to generate electric energy. Therefore, bidirectional power generation when the key panel 10 is pressed and rebounds is achieved, and the power generation efficiency is improved. Moreover, the present disclosure has the features of simple structure, large and stable power generation, environmental protection, low cost, and convenient mounting.

The control circuit 60 is fixedly mounted on the base 50 through the circuit board 61, and the wireless switch 100 controls the controlled device 200 through the control circuit 60. The rectifier module 62 is configured to store the electric energy corresponding to the induced voltage generated by the induction part 43 in the energy storage module 63. The energy storage module 63 is configured to transmit the stored electric energy to the voltage output module 64. The voltage output module 64 is configured to provide a required power supply voltage to the processor 65, the memory 66 and the wireless communication module 67 by using the transmitted electric energy, thus enabling the power-on operation of the processor 65, the memory 66 and the wireless communication module 67.

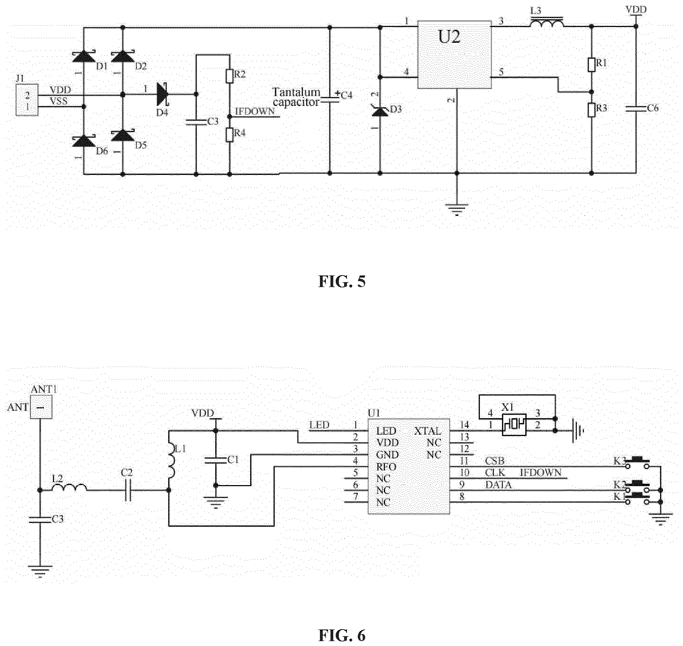

Please refer to FIG. 5, specifically, the rectifier module 62 includes a first rectifier diode D1 and a second rectifier diode D2. The induced voltage generated by the power generation module 40 is stored in a tantalum capacitor C4 of the energy storage module 63 after passing through the first rectifier diode D1 and the second rectifier diode D2 in the rectifier module 62. The voltage output module 64 includes a voltage regulator chip U2, a voltage regulator tube L3, a filter capacitor C6, a voltage division resistor R1, and a voltage division resistor R3. The input side of the voltage regulator chip U2 is electrically connected to the energy storage module 63, the output side of the voltage regulator chip U2 is electrically connected to the first end of the voltage regulator tube L3, the filter capacitor C6 is electrically connected between the second end of the voltage regulator tube L3 and the ground, and the filter capacitor C6 is connected in parallel with the voltage division resistor 1 and the voltage division resistor 3. The voltage regulator chip U2 can control switch-on and switch-off between the input side and the output side, and achieve the purpose of adjusting an output voltage by adjusting the on-off switching frequency and the switch-on and switch-off duration. Further, the voltage output module is further provided with a voltage division circuit, including a filter capacitor C3, a voltage division resistor R2 and a voltage division resistor R, so that the output voltage of the voltage output module 64 can be controlled between 1.8 V and 3.6 V, and a stable voltage is provided for the processor 65, the memory 66 and the wireless communication module 67.

Please refer to FIG. 5 and FIG. 6, in this embodiment, the voltage division circuit is further provided with a fourth rectifier diode D4, and an emission node IFDOWN is provided between the voltage division resistor R2 and the voltage division resistor R4. Through the rectification of the fourth rectifier diode D4, the emission node IFDOWN can be used as a signal output end of the voltage output module 64 to output a fixed signal. The other end of the emission node IFDOWN may be electrically connected to a fixed pin of an emitting chip U1 in the wireless communication module 67, thus emitting a fixed signal to the controlled device 200 through the wireless communication module 67. The emitting chip is further provided with at least one signal pin. In this embodiment, the signal pin includes a signal pin K1, a signal pin K2, and a signal pin K3, which are grounded by detection switches and can be controlled by the processor 65 to be connected or disconnected. It may be understood that the signal pin K1, the signal pin K2 and the signal pin K3 may correspond to different keys 53 so as to be selectively connected under the control of the processor 65, thereby making the wireless communication module 67 emit a corresponding control instruction.

The processor 65, after receiving different signals from the circuit board 61, is configured to compare the different signals with a key information instruction set which is stored in the memory 66 in advance, so as to produce a corresponding control signal, and then the signal pin corresponding to the control signal is connected to make the wireless communication module 67 send a control instruction to the corresponding controlled device 200.

The wireless switch 100 of the present disclosure can be triggered through the signal pin when the key panel 10 is pressed, so as to turn on the functions of the corresponding controlled device 200, and the fixed signal is emitted through the emission node IFDOWN, so as to turn off the functions of the corresponding controlled device 200.

During operation of the wireless switch 100, when the key panel 10 is pressed, the drive part 41 undergoes elastic deformation to drive the moving part 42, thus making the moving part 42 move towards a first direction; the reset component 45 is elastically compressed, and at the moment, the induction part 43 generates an induced voltage, and the induced voltage is stored in the energy storage module 63 after being rectified by the rectifier module 62. The voltage output module 64 is configured to transmit the electric energy stored in the energy storage module 63 to the processor 65, the memory 66 and the wireless communication module 67. Meanwhile, the key 53 at the corresponding pressing region of the key panel 10 is elastically compressed to cause the generation of a corresponding signal on the circuit board 61, and the signal is received by the processor 65. The processor 65, after receiving the signal of the circuit board 61, is configured to compare the signal with an instruction set stored in the memory 66, so as to produce a corresponding control signal, and then a control instruction is sent to the corresponding controlled device 200 through the wireless communication module 67. For example, when the light needs to be turned on, the key 53 region corresponding to the turn of light on the key panel 10 can be pressed, a control signal for turning the light on is generated by the processor 65, and a control instruction is sent to the light in the controlled device 200 through the wireless module 67 to turn on the light. When the light needs to be turned off, the key panel 10 is enabled to rebound, a fixed signal is sent by the processor 65 through the emission node IFDOWN of the voltage output module 64, and a control instruction is sent to a light in the controlled device 200 through the wireless module 67 to turn off the light.

In accordance with the wireless switch 100 provided by the embodiment of the present disclosure, in the control circuit 60, the induced voltage generated by the induction part 43 is rectified by the rectifier module 62, and the rectified electric energy is transmitted to the energy storage module 63 for storage. The voltage output module 64 can generate a power supply voltage based on the electric energy stored in the energy storage module 63 and supply power to a circuit part that needs electricity, thus forming stable power supply, avoiding the waste of electric energy, and achieving efficient utilization of the electric energy. In addition, by providing a simple one-way filter voltage division circuit, the power consumption of the circuit cannot be increased, and the emission power of the circuit is guaranteed. On this basis, as the stable power supply in the wireless switch 100 is conducive to guaranteeing the accuracy and timeliness of the information sending, the timeliness and accuracy of the control between the wireless switch 100 and the controlled device 200 are guaranteed.

In the present disclosure, unless expressly specified and limited otherwise, the terms "install", "connected", "connection", "fix", and the like should be understood broadly, e.g., may be either a fixed connection or a detachable connection, or a connection in one piece; may be a direct connection or an indirect connection through an intermediate medium, may be an internal communication between the two elements or interactions between the two elements. For those of ordinary skill in the art, the specific meanings of the above terms in the present disclosure can be understood on a case-by-case basis.

In the description of this specification, reference terms "an embodiment", "some embodiments", "an example", "a particular example", or "some examples" mean that a particular feature, structure, material, or characteristic described in conjunction with the embodiment or example is included in at least one embodiment or example of the present disclosure. In this specification, exemplary descriptions of aforesaid terms are not necessarily referring to the same embodiment or example. Moreover, the described particular features, structures, materials, or characteristics may be combined in a suitable manner in any one or more embodiments or examples. In addition, those skilled in the art may combine the different embodiments or examples and the features of the different embodiments or examples described in this specification without contradicting each other.

Although the embodiments of present disclosure have been shown and described above, those of ordinary skill in the art shall understand that various changes, modifications, replacements and variations may be made to these embodiments without departing from the principle and spirit of the present disclosure, and the scope of the present disclosure is defined by the claims and their equivalents.

## Claims

1. A wireless switch configured to control a controlled device, comprising a key panel, wherein the wireless switch further comprises a power generation module; the power generation module comprises a drive part, a moving part, an induction part, and a reset component; when the key panel is subjected to a control action of pressing, the drive part undergoes elastic deformation to drive the moving part, thus enabling the moving part to move towards a first direction, and the reset component undergoes elastic deformation to produce a reset force to overcome the deformation; and when the pressing force on the key panel is removed, the reset force is used by the reset component to urge the elastic recovery of the drive part to drive the moving part, thus enabling the moving part to move towards a second direction and enabling the key panel to rebound.

2. The wireless switch according to claim 1, wherein the wireless switch further comprises a fixing frame, the key panel is provided with a pin hole, the fixing frame is provided with a hinge pin, and the key panel is rotatably mounted into the fixing frame by inserting the hinge pin into the pin hole.

3. The wireless switch according to claim 2, wherein the wireless switch further comprises a base, and the fixing frame is covered with the base to form an accommodating space, and the power generation module is accommodated into the accommodating space.

4. The wireless switch according to claim 1, wherein the wireless switch further comprises a sealing member; the sealing member is able to cover the power generation module to prevent external dust or liquid from entering; one side, close to the power generation module, of the sealing member is provided with a noise reduction part, and the noise reduction part is of a wavy structure to increase the damping of sound propagation, thereby reducing the sound generated when the key panel is pressed.

5. The wireless switch according to claim 4, wherein the reset component and the sealing member are both made of a silica gel material.

6. The wireless switch according to claim 1, wherein the wireless switch further comprises a control circuit; the control circuit comprises a rectifier module, and the induction part is electrically connected to the rectifier module to generate an induced voltage when the moving part moves towards the first direction as well as the second direction.

7. The wireless switch according to claim 6, wherein the control circuit further comprises an energy storage module; the rectifier module is electrically connected to the energy storage module; the rectifier module comprises a first rectifier diode and a second rectifier diode; the induced voltage generated by the power generation module is stored in a tantalum capacitor of the energy storage module after passing through the first rectifier diode and a second rectifier diode in the rectifier module.

8. The wireless switch according to claim 7, wherein the control circuit further comprises a voltage output module, a processor, a memory, and a wireless communication module; the energy storage module is electrically connected to the voltage output module, the voltage output module is electrically connected to the processor, the memory and the wireless communication module, so as to output a required power supply voltage to the processor, the memory and the wireless communication module by using electric energy transmitted from the energy storage module, and thus the processor, the wireless communication module and the memory are powered on.

9. The wireless switch according to claim 8, wherein the voltage output module is provided with a voltage division circuit; the voltage division circuit is provided with a fourth rectifier diode and two voltage division resistors, and an emission node is arranged between the two voltage division resistors; and the emission node is used as a signal output end of the voltage output module to output a fixed signal.

10. The wireless switch according to claim 9, wherein the wireless communication module is able to be in communication with the controlled device, and the processor is electrically connected to the wireless communication module, so as to send a control instrument to the controlled device by using the wireless communication module after the processor, the memory and the wireless communication module are powered on.
